# EUROPÄISCHE PATENTSCHRIFT

(11) **EP 2 197 252 B1**
(45) Veröffentlichungstag und Bekanntmachung des Hinweises auf die Patenterteilung: **21.11.2012**
(21) Anmeldenummer: 09015374.3
(22) Anmeldetag: 11.12.2009
(51) Int. Cl.: H05K 1/14, H05K 1/18, H05K 3/00, H01R 43/02, H04M 1/02, H05K 3/30

(54) **System mit skalierbarem Kamerakontaktblock, Verfahren zur Herstellung des Systems und Verfahren zum Einbau insbesondere einer SMD-Kamera in das Gehäuse eines Mobiltelefons**
System with scalable camera contact block, method for producing the system and method for installing, in particular a SMD camera in the housing of a mobile telephone
Système avec bloc de contact de caméra échelonnable, procédé de fabrication du système et procédé d'installation, notamment d'une caméra SMD, dans le boîtier d'un téléphone mobile

(30) Priorität: 15.12.2008 DE 102008062261
(43) Veröffentlichungstag der Anmeldung: 16.06.2010
(73) Patentinhaber: Amphenol-Tuchel Electronics GmbH, 74080 Heilbronn (DE)
(72) Erfinder: Braun, Gerhard, 74626 Bitzfeld (DE)
(74) Vertreter: Wagner, Karl H.

(56) Entgegenhaltungen:
- WO-A1-2004/110034
- DE-A1-102006 019 511
- US-A1- 2001 000 905
- US-A1- 2004 212 718
- US-A1- 2004 256 715
- US-A1- 2005 287 829
- US-A1- 2007 238 324
- US-B1- 6 332 782

## Beschreibung

Die vorliegende Erfindung bezieht sich auf einen Kamerakontaktblock sowie dessen Herstellung, wobei der Kamerakontaktblock ein einfaches skalierbares Bauteil ist, um eine Standard-SMD-Kamera (im folgenden einfach: Kamera) an unterschiedliche Mobiltelefon-Gehäuse anzupassen, so dass bei der Herstellung des Mobiltelefons eine beträchtliche Kostenersparnis erreicht wird.

Bekanntlich werden bei der Herstellung eines Mobiltelefons in zunehmendem Maße fotografische Kameras in das Gehäuse des Mobiltelefons eingesetzt. Beim Einbau einer Kamera, insbesondere einer SMD-Kamera in das Gehäuse eines Mobiltelefons wird im Allgemeinen ein Pick- und Place-Verfahren eingesetzt, und es muss auf große Effizienz Wert gelegt werden.

Wenn eine Standard-SMD-Kamera in das Gehäuse eines Mobiltelefons eingebaut wird, so muss das SMD-Kontaktfeld der SMD-Kamera auf der Kontaktanordnung (contact array) oder dem Kontaktfeld einer Platine (bzw. Leiterplatte) platziert und kontaktiert werden, d. h. die Kontaktierung erfolgt mit dem Teil des gesamten Kontaktfelds der Platine welches für die Kontaktierung der SMD-Kamera vorgesehen ist. Diese elektrische Verbindung der SMD-Kamera mit der Platine des Mobiltelefons kann sich dann schwierig gestalten, wenn die Verbindung der SMD-Kamera direkt mit dem entsprechenden Kontaktfeld der.Kamera erfolgt und sich herausstellt, dass die SMD-Kamera viel zu tief im Mobiltelefon zu liegen käme, wenn die bevorzugten Abmessungsverhältnisse des Gehäuses eingehalten werden sollen.

Die DE 10 2006 019511 A1 beschreibt eine Wandlereinheit zur Verwendung in einer Kamera oder einem Nachtsichtgerät, wobei ein Bildwandler vorgesehen ist, der von einer Zwillingsplatine getragen ist. Die Zwillingsplatine umfasst zwei beabstandete Plattensegemente, deren Randkontur jeweils im Wesentlichen mit der Randkontur des Bildwandlers übereinstimmt.

Die US 2004/212718 A1 beschreibt ein Kameramodul, welches in einem, auf einer bedruckten Schaltungsplatte angeordneten Rahmen untergebracht ist. Dabei ist die Anordnung derart getroffen, dass die Optik des Kameramoduls im Wesentlichen innerhalb des Rahmens, der dafür eine Öffnung besitzt angebracht oder angeordnet ist.

Die WO 2004/110034 A1 beschreibt in Mobilfunkgerät mit einer im Mobilfunkgerätegehäuse anordneten Leiterplatte. Dabei ist die Kamera direkt auf die Leiterplatte des Mobilfunkgeräts gelötet, wobei im zusammengebauten Zustand des Mobilfunkgerätes vor der Kamera im Mobilfunkgerätgehäuse, eine Öffnung vorgesehen ist.

Die US2007/238324 A1 zeigt einen elektrischen Verbinder, der die Verbindung zwischen zwei elektronischen Vorrichtungen herstellt und zwar mittels eines zusammendrückbaren Kontaktes, der einen elektrischen Verbinderkörper aufweist, der eine Vielzahl von Durchtrittsöffnungen besitzt.

Die US 2004/256715 A1 beschreibt ein Substrat mit einem Halbleiterelement mit einem Zwischenglied welches Leiter aufweist, die säulenförmig durch Isolierschichten des Zwischenglieds verlaufen.

Die US 6 332 782 B1 lehrt eine Zwischenverbindungssubstratstruktur zur elektrischen Verbindung zweier elektronischer Module, die unterschiedliche Leitungsanordnungen besitzen.

Die US 2005/287829 A1 beschreibt eine Vorrichtung zur Anbringung und elektrischen Verbindung von Kontakten beispielsweise eines Verpackungssubstrats mit einer gedruckten Schaltungsplatte.

Schließlich beschreibt die US 2001/000905 A1 ein Substrat in der Form einer Schaltungsplatte mit einer Vielzahl von daraus angeordneten Modulen unter Verwendung von Lötpunkten.

Darüber hinaus ist es wünschenswert, dass auch bei unterschiedlichen Kameramodellen die Kamera an einer beliebigen Stelle des Gehäuses anzubringen ist, ohne dass Probleme bei der Verbindung der SMD-Kamera mit der Platine des Mobiltelefons auftreten.

Eine weitere Schwierigkeit ergibt sich dadurch, dass die modernen Mobiltelefone, obwohl sie mit einer Kamera ausgerüstet sind, klein und insbesondere flach sein sollen und dass die Kamera an unterschiedlichen Stellen im Gehäuse angeordnet werden soll.

Heute schon sind SMD-Kameras auf dem Markt, die wesentlich kleiner sind als ein normaler Würfel, die also beispielsweise die Größe einer Taste eines Mobiltelefons besitzen. In einem großen Teil des Mobiltelefons verläuft die nur 3 oder 4 mm dicke Platine im Regelfall näher an der Vorderseite (Tastaturseite) des Gehäuses, während die Rückseite des Gehäuses üblicherweise mit einem größeren Abstand bezüglich der Platine angeordnet ist. Bei an der Rückseite des Gehäuses anzubringender oder angebrachter SMD-Kamera müssen beispielsweise bis zur Leiterplatte Abstände von 5, 6 oder 7 mm überbrückt werden. Für einen Kamerakontaktblock in der Form eines KameraInterposers (Kontaktblock, Zwischenteil) mit einer Größe von ca. 3 mm x 3 mm x 2 mm ergibt sich ein typischer Abstand von 2 mm Höhe.

Zur Lösung dieser Problematik sieht die Erfindung einen skalierbaren Kamerakontaktblock vor, der das direkte Anlöten der Kamera an der Platine vermeidet, und den erfindungsgemäß vorgesehenen skalierbaren Kamerakontaktblock einsetzt, der je nach dem zu überbrückenden Abstand zur Platine eine unterschiedliche Stärke oder Dicke besitzt. Die Form des Kamerakontaktblocks kann so gestaltet sein, dass auch eine ungünstig im Telefongehäuse platzierte SMD-Kamera mit der Platine verbunden werden kann. Da allerdings die Größe eines typischen Kamerakontaktblocks nur 3 mm x 3 mm x 2mm beträgt, besteht eine besondere Schwierigkeit darin, die Anzahl der Kontakte im Kamerakontaktblock zu plazieren. Da eine SMD-Kamera über ein Kontaktmatrixfeld zum Anschluss verfügt, müssen darüber hinaus die exakten Positionen eingehalten werden.

Eine weitere Schwierigkeit besteht darin, über die gesamte Höhe des Kamerakontaktblocks Kontakte vorzusehen, die als lötfähige Kontakte ausgebildet sind, so dass an der Oberfläche des Kamerakontaktblocks eine Lötkontaktanordnung bereitgestellt wird, die geometrisch und technisch so ausgebildet ist, dass diese den Bedingungen auf der Leiterplatte vorzugsweise den notwendigen Reflow-Lötbedingungen, genügt.

Die Erfindung sieht zur Lösung dieser Problematik ein System mit einem skalierbaren Kamerakontaktblock gemäß Anspruch 1 vor. Bevorzugte Ausgestaltungen sind in den vom Anspruch 1 abhängigen Unteransprüchen genannt.

Die Erfindung sieht ferner ein Verfahren gemäß Anspruch 10 vor, und zudem ein Verfahren nach Anspruch 13 zum Zusammenbau eines Mobiltelefons unter Verwendung eines auch als Distanzblock (Interposer) zu bezeichnenden Kamerakontaktblocks.

Erfindungsgemäß wird der Kamerakontaktblock als skalierbarer Kamerakontaktblock vorgesehen, in dem folgende Verfahrensschritte durchgeführt werden:
a) Bereitstellen eines UV-härtbaren flüssigen Kunststoffes;
b) Anordnen einer Maske, wobei die Maske über eine Matrix verfügt, welche Bereiche a) definiert, welche ausgehärtet werden und Bereiche b) definiert, welche unausgehärtet bleiben;
c) Aushärten einer ersten Schicht des UV-härtenden Kunststoffs mit UV-Strahlen durch die Maske hindurch;
d) Schrittweiser Aufbau des Kamerakontaktblocks durch Wiederholen des Verfahrensschrittes c) mittels n-Schritten solange, bis die gewünschte Kamerakontaktblockhöhe erzeugt wird mit der gewünschten Anzahl der durchgehenden Ausnehmungen (Kanäle);
e) Metallisieren der durchgehenden Kanäle von der Unterseite bis zur Oberseite des Kontaktblocks;
f) Verschließen der verbliebenen Öffnungen in den Kanälen, vorzugsweise mittels aushärtbarem Kunststoff durch Anordnen einer geeigneten Maske;
g) Galvanisieren der an der Oberfläche gebildeten, im Wesentlichen ringartige, ausgeformten metallisierten Oberflächenbereiche mittels einer Galvanikschicht.

Das zuvor beschriebene Verfahren kann auch dahin abgewandelt werden, dass vor dem Galvanisieren der an der Oberfläche befindlichen Metallisierung der Kamerakontaktblock geschliffen wird, so dass eine ebene Oberfläche ausgebildet wird, bei der die zuvor metallisierten Kanäle planar freigelegt werden. Dabei wird auch eine Oberflächenstruktur erzeugt, an welcher an den entsprechend vorgesehenen Stellen, sozusagen ringförmig ausgebildete Kontaktenden der im Wesentlichen zylindrisch ausgebildeten durch den Kontaktkörper hindurch geführten Metallisierungen, freigelegt werden. Diese können mittels herkömmlichen Galvanisierens beschichtet werden. Damit beim Galvanisierungsprozess in Folge der Kapillarwirkung keine Metallreste oder andere Verunreinigungen in die Kontaktkanäle des Kamerakontaktblocks eintreten, wird vorzugsweise, wie im Schritt f) des Verfahrens angegeben, ein Verschließen der Kanäle vor dem Galvanisieren vorgenommen.

Mit Vorteil kann durch das zuvor beschriebene Verfahren die Dicke der Kontaktblöcke (Interposer) mit erheblicher Genauigkeit hergestellt werden.

Als alternatives Herstellungsverfahren kann, statt der Metallisierung der im Verfahren bei der Herstellung des Kamerainterposers erzeugten Kanäle (Aussparungen, Durchbrüche) an den entsprechenden Positionen, ein Metalldraht in die Kanäle eingeführt werden.

Vorzugsweise kann der Metalldraht in seinem Durchmesser so gewählt werden, dass er mittels einer formschlüssigen Presspassung in den Kontaktblock (Kamera-Interposer) eingeführt wird. Die überstehenden Enden können mittels eines Scherverfahrens an der Ober- und Unterseite abgeschert werden. Hierdurch wird ein Kamerakontaktblock mit durchgehenden und vollständig gefüllten Kontaktkanälen erzeugt. Die Kontaktenden können, wie zuvor beschrieben, mittels eines herkömmlichen Galvanisierungsprozesses veredelt werden.

Weitere Vorteile, Ziele und Einzelheiten der Erfindung ergeben sich aus der Beschreibung von Ausführungsbeispielen anhand der Zeichnungen; in der Zeichnung zeigt:
- Fig. 1: eine schematische Darstellung der Anordnung eines erfindungsgemäßen Kontaktblocks zwischen zwei Gehäuseteilen (einem rechten, vorderen und einem linken, hinteren) eines Mobiltelefons, und zwar in der Endmontageposition;
- Fig. 2: eine schematische Darstellung einer Möglichkeit eines Zusammenbaus der Gehäuseteile, wobei an der Platine ein Kamerakontaktblock mit daran angeschlossener SMD-Kamera vorgesehen ist und die Kamera am hinteren Gehäuseteil zu befestigen ist;
- Fig. 3: die bevorzugte umgekehrte Verfahrensweise beim Zusammenbau des Gehäuses der Mobilkamera, wobei hier an der SMD-Kamera der skalierte Kamerakontaktblock angebracht ist, der seinerseits noch mit der Platine zu verbinden ist;
- Fig. 4: schematisch ein Beispiel, bei dem die SMD-Kamera an einer Einbuchtung des hinteren Gehäuseteils angeordnet ist, und über einen skalierten Kontaktblock mit der Platine verbunden ist;
- Fig. 5: schematisch die Verbindung einer SMD-Kamera mit der Platine, unter Verwendung eines skalierten Kamerakontaktblocks;
- Fig. 6: eine Draufsicht auf ein Ausführungsbeispiel eines Kamerakontaktblocks;
- Fig. 7: eine Seitenansicht des Kontaktblocks der Fig. 6;
- Fig. 8: eine perspektivische Ansicht eines weiteren Ausführungsbeispiels eines Kontaktblocks;
- Fig. 9: ein weiteres Ausführungsbeispiel eines Kontaktblocks;
- Fig.10 u. 11: Verfahrensschritte bei der Herstellung eines Kontaktblocks gemäß einem ersten Ausführungsbeispiel.

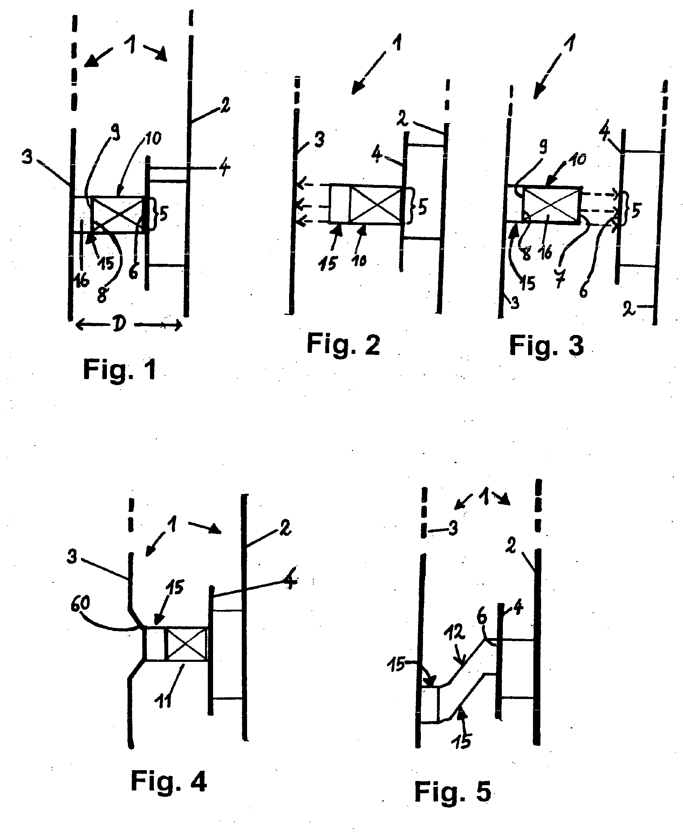

Fig. 1 zeigt außerordentlich schematisch einen Schnitt durch ein Mobiltelefongehäuse 1. Das Mobiltelefongehäuse 1 besteht vorzugsweise aus zwei Gehäuseteilen, nämlich einem vorderen Gehäuseteil 2 (Tastenfeldgehäuseteil) und einem hinteren Gehäuseteil 3 (einem eine Kameraöffnung aufweisenden Gehäuseteil 3). Zwischen den beiden Gehäuseteilen 2 und 3 sind insbesondere angeordnet: eine Leiterplatte oder Platine 4, ein erfindungsgemäßer skalierbarer, einen Isolierkörper 16 aufweisenden Kamerakontaktblock 10 und eine Kamera vorzugsweise eine SMD-Kamera 15. Die Platine 4 ist üblicherweise mit dem vorderen Gehäuseteil 2 in nicht näher dargestellter Weise (hier durch zwei Striche angedeutet) verbunden und nimmt im Raum zwischen dem vorderen und dem hinteren Gehäuseteil 2, 3 eine bestimmte Position ein. In einem mit 5 angedeuteten Kontaktfeldbereich sind an der Platine 4 Kontakte angeordnet, und zwar in einem ins Gehäuseinnere weisenden Kontaktfeld 6. An diesem Kontaktfeld 6, werden wie in Fig. 3 gezeigt, üblicherweise die Kontakte eines zweiten Kontaktfeldes 7 des Kamerakontaktblocks 10 angelötet, nachdem der Kamerakontaktblock 10 zusammen mit der SMD-Kamera 15 und hinterem Gehäuseteil 3 entlang der gestrichelten Pfeile auf die Platine 4 hin bewegt wurde (Fig. 3). Der Kamerakontaktblock 10 besitzt ferner ein erstes Kontaktfeld 9 zur Kontaktierung und Befestigung mit einem Kontaktfeld 8 der Kamera 15. Erfindungsgemäß sind Leitermittel im Kontaktblock vorgesehen, welche die Kontakte des zweiten Kontaktfeldes 7 mit den Kontakten des ersten Kontaktfeldes 9 verbinden.

Gemäß einem bevorzugten Ausführungsbeispiel - vergl. Fig. 3 - wird der in Fig. 1 gezeigte Endzustand des Mobiltelefons dadurch erreicht, dass man das erste Kontaktfeld 9 des Kamerakontaktblocks 10 mit dem Kontaktfeld 8 der SMD-Kamera 16 verlötet, worauf dann die Fertigstellung durch Anlöten des Kontaktfelds 7 des Kamerakontaktblocks 10 am Kontaktfeld 6 der Leiterplatte 4 erfolgt.

### Der skalierbare Kontaktblock 10 weist also folgendes auf:

Einen Isolierkörper 16 mit einer ersten Kamera-Auflagefläche, die ein erstes Kontaktfeld 9 zur Kontaktierung des Kontaktfeldes 8 der Kamera 15 aufweist und mit einer zweiten Platinen-Auflagefläche die ein zweites Kontaktfeld 7 zur Kontaktierung des für die Kamera 15 vorgesehenen Kontaktfeldes 6 der Platine 4 aufweist, und im Isolierkörper 16 angeordnete Leitermittel zur Verbindung der Kontakte des ersten Kontaktfeldes 9 mit den Kontakten des zweiten Kontaktfeldes 7 wobei der Abstand der ersten Auflagefläche von der zweiten Auflagefläche des Isolierkörpers 16 derart gewählt ist, dass ein vorgegebener Abstand D zwischen den ersten und zweiten Gehäuseteilen 2, 3 eingehalten wird.

Fig. 2 stellt eine weniger bevorzugte Verfahrensweise vor, gemäß welcher Kontaktblock 10 und SMD-Kamera 15 zusammen an die Platine 4 angelötet werden, worauf und dann die Anbringung der hinteren Gehäusehälfte 3 an der SMD-Kamera 15 erfolgt.

Fig. 4 zeigt schematisch die Verwendung eines skalierbaren Kamerakontaktblocks 11 zum Ausgleich einer gegenüber einer Vertiefung 60 des hinteren Gehäuses 3 angeordneten Kamera 15.

Fig. 5 zeigt ein Ausführungsbeispiel, bei dem ein Kamerakontaktblock 12 eine beträchtliche Fehlausrichtung zwischen Kamera 15 und Kontaktfeld 6 der Platine 4 überbrückt.

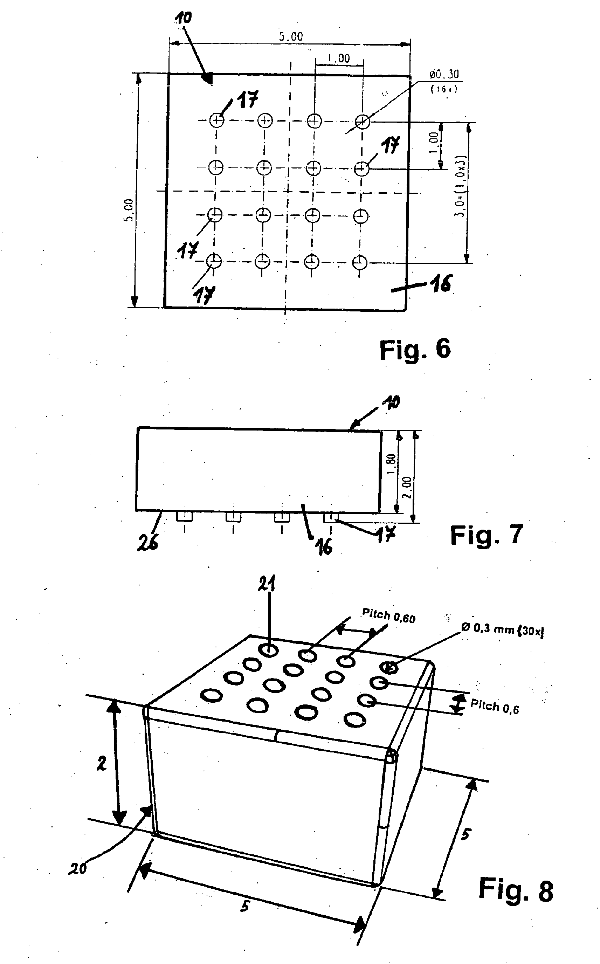

Die Figuren 6 und 7 zeigen ein konkretes Ausführungsbeispiel eines Kamerakontaktblocks z.B. 10, der einen Isolierkörper 16 aufweist, in den Leiter 17 in der Form von Drähten 17 eingepresst sind, die wie in Fig. 7 gezeigt, über die Unterseite 26 des Isolierkörpers 16 hinausragen. Die Figuren 6 und 7 geben bevorzugte und beispielhafte Abmessungen für den Kontaktblock 10 an, und zwar ist die die Kontakte aufweisende Fläche des Kontaktblocks 10 insgesamt 5 x 5 mm groß. Dabei bilden die Enden der Leiter bzw. Drähte 17 diese in Fig. 6 gezeigten Kontakte. Der Kontaktabstand beträgt 1 mm, und die Höhe des Kontaktblocks 10 bzw. Isolierkörpers 16 beträgt 1,8 mm, wobei die Drähte 17 mit dem Kontaktende 0,2 mm über die Unterseite des Kontaktblocks 10 hinausragen (Fig. 7).

Fig. 8 zeigt eine perspektivische Ansicht eines kubischen Kontaktblocks 10 mit einem Kontaktfeld, dessen Kontakte 21 durch Enden vom Leiter 17 gebildet werden.

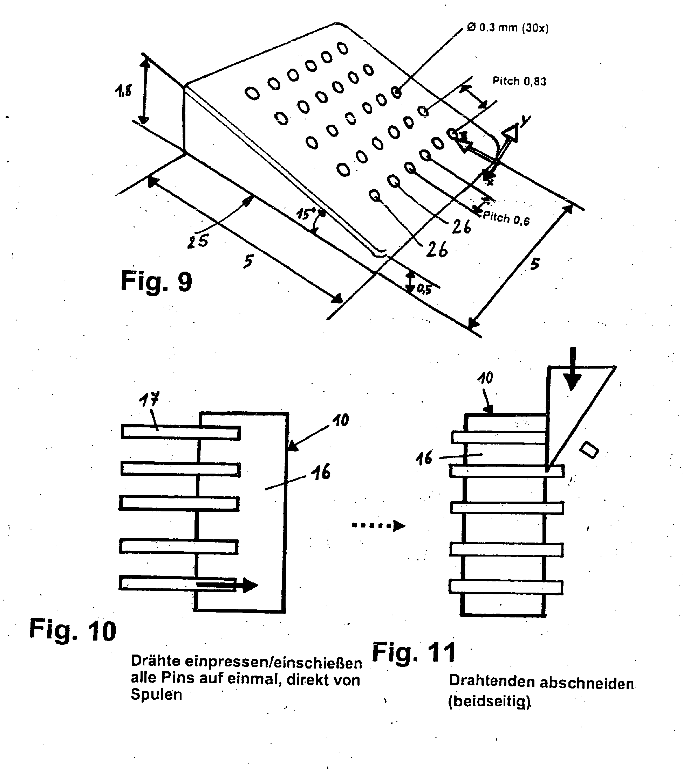

Fig. 9 zeigt (ähnlich wie Fig. 8) einen Kontaktblock 25 aber hier mit einer abgeschrägten Oberseite, an der Kontakte 26 in einem Kontaktfeld angeordnet sind.

Die Figuren 10 und 11 veranschaulichen ein erfindungsgemäßes Verfahren zur Herstellung eines Ausführungsbeispiels eines Kontaktblocks 10, wie er beispielsweise in der Fig. 8 dargestellt ist. Gemäß diesem Verfahren werden von einer Rolle kommende Leiter bzw. Drähte 17 in den Isolierkörper 16 des Kontaktblocks 10 eingepresst und anschließend abgeschnitten.

Wenn die verwendeten von der Rolle kommenden Drähte 17 aus Standard-Kontaktmaterial bestehen, so müssen die Trennflächen nachträglich mit einem lötbaren und/oder alterungsbeständigen Bezug beschichtet werden.

Um eine nachträgliche Beschichtung nicht erforderlich zu machen, könnten die einzupressenden Leiter 17 auch aus Zinn oder einer lötbaren Legierung bestehen.

Es wird darauf hingewiesen, dass bei der Aufbringung einer Lotpaste mit Siebdruck zuerst nur das Lotdepot für die Verbindung zwischen der Platine 4 und dem Kontaktblock 10, 11 oder 12 erstellt werden kann. Die Oberseite des Kontaktblocks kann dann vor der weiteren Bestückung mit Lotpaste versehen werden, da sonst das Lot durch einen zur Bestückung verwendeten Vakuumgreifer angesaugt werden würde.

Weiterhin wird die SMD-Kamera 15 mittels eines anisotropen Leitklebers auf den ausgewählten skalierbaren Kontaktblock aufgeklebt. Sodann wird die SMD-Kamera 15 am Kontaktblock mittels eines Lotes, das einen höheren Schmelzpunkt als das Standard SMD-Lot aufweist, angelötet. Dadurch wird verhindert, dass sich diese erste Lötverbindung während des nachfolgenden Hauptlötprozesses oder beim Über-Kopf-Löten wieder löst.

Da bei der Vorbestückung der SMD-Kamera 15 mit dem Kamerakontaktblock 10 die Verbindungsfläche mittels entsprechender Aufnahmen horizontal ausgerichtet werden kann, besteht hierbei nicht die Gefahr, dass die SMD-Kamera 15 abrutscht.

Im Übrigen sollte für eine optimale Platzierung der SMD-Kamera 15 innerhalb des Mobiltelefons diese am Rande des Telefons plaziert werden. In dieser Position muss die Oberseite der SMD-Kamera 15 mit einer nicht gezeigten schrägen Pick- und Place-Haube versehen werden, die nach dem Löten wieder entfernt wird. Weiterhin kann mit dieser Haube durch eine entsprechende Geometrie ein Kippen der Kamera 15 verhindert werden.

Im Folgenden wird noch ein hier nicht veranschaulichtes bevorzugtes Verfahren zur Herstellung eines Kamerakontaktblocks 10, 11, 12 beschrieben. Bei diesem Verfahren ist der Kontaktblock schichtweise aus einem flüssigen Kunststoff aufgebaut. Dies geschieht dadurch, dass Lage auf Lage eines flüssigen Kunststoffs aufgebracht wird, der verfestigt wird, wobei immer nach Verfestigung einer vorherigen Lage eine neue Lage aufgebracht wird, und wobei eine Maske eingesetzt wird, um so beim schichtweisen Aufbau des Isolierkörpers eine Anzahl von Löchern oder Kanälen darin entstehen zu lassen.

In diese Kanäle werden nicht wie zuvor beschrieben Drähte eingepresst, sondern vielmehr werden mittels eines Dampfabscheidungsverfahrens, einem PVD (physical vapor deposition)-Verfahren vorzugsweise Metallhülsen als Leiter 17 gebildet, die zylinderförmig sind und durch die gebildeten Kanäle im Isolierkörper verlaufen. Nachdem ein Kontaktblock 10, 11, 12 dieser Bauart infolge der metallisierten Röhren nicht ohne Weiteres durch das beim Pick- und Place-Verfahren verwendete Vakuum angesaugt und gehalten werden könnte, werden erfindungsgemäß die von den Röhren gebildeten Löcher ebenfalls an der Oberseite verschlossen. Dies erfolgt dadurch, dass abschließend eine Kunststoffschicht über den ganzen Körper des Kontaktblocks hinweg aufgebracht wird, wobei Kunststoff auch in die von den Röhren gebildeten Hohlräume fließt. Darauffolgend wird der die Hohlräume verschließende Kunststoff angeschliffen, wobei ringförmige von der Metallisierung gebildete Kontaktpunkte entstehen. Diese können dann wieder galvanisiert werden, es kann Lotpaste aufgebracht werden, und die SMD-Kamera 5 kann aufgelötet werden.

Die Verwendung des Schichtverfahrens ist vorteilhaft um die erforderliche Detailgenauigkeit zu erreichen, die mit einem normalen Spritzwerkzeug nicht zu erreichen ist.

## Patentansprüche

1. Ein System bzw. eine Anordnung bestehend aus:
a) einem Gehäuse (1) eines mindestens zwei Gehäuseteile (2, 3), ein vorderes Gehäuseteil (2) und ein hinteres Gehäuseteil (3), aufweisenden Mobiltelefons,
b) einer am hinteren Gehäuseteil (3) befestigten Kamera (15), insbesondere einer SMD Kamera, mit einem Kontaktfeld (8) zur elektrischen Verbindung der Kamera (15) mit einem an einer mit dem vorderen Gehäuseteil (2) verbundenen Platine (4) des Mobiltelefons vorgesehenen Kontaktfeld (6),
c) einem skalierten Kontaktblock (10, 11, 12) zum Einsatz im Gehäuse (1),
wobei der skalierte Kamerakontaktblock (10, 11, 12) Folgendes aufweist:
einen Isolierkörper (16) mit einer ersten Kamera-Auflagefläche, die ein erstes Kontaktfeld (9) zur Kontaktierung des Kontaktfeldes (8) der Kamera (15) aufweist und
mit einer zweiten Platinen-Auflagefläche die ein zweites Kontaktfeld (7) zur Kontaktierung des für die SMD Kamera (15) vorgesehenen Kontaktfeldes (6) der Platine (4) aufweist,
wobei der Isolierkörper (16) zur elektrischen Verbindung des Kontaktfeldes (8) der Kamera (15) mit dem für die Kamera (15) vorgesehenen Kontaktfeldes (6) vorgesehen ist, und
wobei die Kontakte des ersten Kontaktfeldes (9) mit den Kontakten des zweiten Kontaktfeldes (7) des Isolierkörpers (16) verbindende im Isolierkörper vorgesehene Leiter (17, 21) vorgesehen sind, und wobei
die dem Abstand zwischen erster und zweiter Auflagefläche entsprechende Höhe des Kontaktblocks (10, 11, 12) ist, so gewählt, dass sie den Abstand von Kamera (15) zu Platine (4) bei geschossenem Gehäuse (1) überbrückt.

2. System nach Anspruch 1, derart gestaltet, dass die Leiter massive Drähte sind, wobei die über die Auflageflächen des Isolierkörpers vorstehenden Drahtenden abgeschnitten sind.

3. System nach Anspruch 1, derart gestaltet, dass die Leiter rohrförmig ausgebildet sind.

4. System nach einem oder mehreren der vorhergehenden Ansprüche, wobei der Kontaktblock (10, 11, 12) aus einer Vielzahl von Schichten aufgebaut ist.

5. System nach einem oder mehreren der vorhergehenden Ansprüche, wobei der Kontaktblock (10, 11, 12) aus UV-härtendem Kunststoff hergestellt ist.

6. System nach einem oder mehreren der vorhergehenden Ansprüche, wobei der Kontaktblock (10, 11, 12) über eine Vielzahl von Kontaktkanälen verfügt, welche an ihrer Innenfläche metallisiert von der ersten Auflagefläche (25) zur zweiten Auflagefläche (26) ausgebildet sind.

7. System nach Anspruch 6, wobei die Kanäle an mindestens einer Stelle mittels eines Kunststoffes innerhalb einer Ebene den Kamerakontaktblock verschließen, **dadurch gekennzeichnet, dass** mindestens ein Kontaktfeld (7, 8) mit einer Galvanikschicht versehen ist.

8. System nach einem oder mehreren der vorhergehenden Ansprüche, wobei die Kontaktfelder (7, 8) an der Auflagenfläche in im Wesentlichen ringförmige Kontaktpunkte bereitstellen.

9. System nach einem oder mehreren der vorhergehenden Ansprüche, wobei die einzelnen Schichten eine Höhe von ca. 5 bis 50 µm aufweisen.

10. Verfahren zur Herstellung eines Systems nach einem der vorhergehenden Ansprüche, wobei Folgendes vorgesehen ist:
a) Bereitstellen eines UV-härtbaren flüssigen Kunststoffes;
b) Anordnen einer Maske, wobei die Maske über eine Matrix verfügt, die Bereiche a) definiert, welche ausgehärtet werden, und die Bereiche b) definiert, welche unausgehärtet bleiben;
c) Aushärten einer ersten Schicht des UV-härtenden Kunststoffs mit ÜV-Strahlen durch die Maske hindurch;
d) Schrittweiser Aufbau des Kamerakontaktblocks mit der gewünschten Anzahl von durchgehenden Ausnehmungen (Kanäle) durch Wiederholen des Verfahrensschrittes c) mittels N-Schritten solange, bis die gewünschte Kamerakontaktblockhöhe erzeugt wird;
e) Metallisieren der durchgehenden Kanäle von der Unterseite bis zur Oberseite des Kontaktblocks;
f) Verschließen der verbliebenen Öffnungen in den Kanälen, vorzugsweise mittels aushärtbarem Kunststoff durch Anordnen einer geeigneten Maske;
g) Galvanisieren der an der Oberfläche gebildeten, im Wesentlichen ringartig, ausgeformten metallisierten Oberflächenbereiche mittels einer Galvanikschicht.

11. Verfahren zur Herstellung eines Systems nach Anspruch 10, wobei die Schichtdicke pro Schicht ca. 5 bis 50µm beträgt.

12. Verfahren zur Herstellung eines Systems nach Anspruch 10 oder 11, wobei die einzelnen Schichten durch optische Übergange voneinander erkennbar angeordnet sind.

13. Verfahren zum Zusammenbau eines Mobiltelefons welches ein System nach einem der Ansprüche 1-9 enthält, wobei das Verfahren, folgende Schritte aufweist:
a) Befestigen einer SMD-Kamera (15);
b) Befestigen eines Kontaktblocks (10, 11, 12) an der Kamera (15);
c) Befestigen einer Platine (4) eines Mobiltelefons an den Kontaktblock (10, 11, 12)

## Claims

1. A system or an apparatus composed of:
a) a mobile phone comprising a housing (1), with at least two housing portions (2, 3), a front housing portion (2) and a back housing portion (3),
b) a camera (15), in particular an SMD camera, mounted at the back housing portion (3) and having a contact field (8) adapted for electrical connection of the camera (15) with a contact field (6) provided on a circuit board (4) that is connectable with the front housing portion (2),
c) a scaled contact block (10, 11, 12) adapted to be inserted into the housing (1),
said scaled contact block (10, 11, 12) comprising:
an insulating body (16) having a first camera abutment surface which comprises a first contact field (9) for contacting the contact field (8) of the camera (15) and
said insulating body (16) further comprising a second circuit board abutment surface having a second contact field (7) for contacting the contact field (6) of the circuit board (4) provided for the SMD camera (15),
wherein said insulating body (16) is provided for the electrical connection of the contact field (8) of the camera (15) with the contact field (6) provided for the camera (15), and
wherein in the insulating body conductors (17, 21) are provided which connect the contacts of the first contact field (9) with the contacts of the second contact field (7) of the insulating body (16), and
wherein the height of the contact block (10, 11, 12) which corresponds to the distance between the first and second abutment surface is selected such, that it bridges the distance of the camera (15) to the circuit board (4) when the housing (1) is closed.

2. The system of claim 1 wherein the conductors are solid wires and the ends of the wires projecting beyond the abutment surfaces of the insulating body are cut off.

3. The system of claim 1 wherein the conductors are designed with tubular shape.

4. The system as set forth in one or more of the preceding claims, wherein the contact block (10, 11, 12) comprises a plurality of layers.

5. The system as set forth in one or more of the preceding claims, wherein in the contact block (10, 11, 12) is made of a plastic material that is hardened by UV.

6. The system as set forth in one or more of the preceding claims wherein the contact block (10, 11, 12) comprises a plurality of contact channels which are metalized at their inner surface extending from the first abutment surface (25) to the second abutment surface (26).

7. The system of claim 6, wherein the channels are closed at least at one location, by means of a plastic material, within a plane the camera contact block
**characterized in that** a contact field (7, 8) is provided with a galvanic layer.

8. The system as set forth in one or more of the preceding claims wherein the contact fields (7, 8) provide at the abutment surface in substance annular contact points.

9. The system as set forth in one or more of the preceding claims wherein the individual layers comprise a height of about 5 to 50 µm.

10. A method for making a system as set forth in one of the preceding claims, said method comprising:
a) providing a liquid plastic material adapted to be solidified by UV;
b) placing a mask, having a matrix defining a) those areas which should be hardened and b) those areas which should remain unhardened;
c) hardening a first layer of the plastic material adapted to be hardened by UV by means of UV radiation through the mask;
d) building up step by step the camera contact block with the desired number of passing recesses (channels) by repeating the method step c), by means of N-steps for as long as required to built up the desired height of the camera contact block;
e) metalizing the passing channels from the bottom side to the upper side of the contact block;
f) closing the remaining openings in the channels, preferably by means of a hardenable plastic material by locating a suitable mask; and
g) galvanizing by means of a galvanic layer the metalized surface areas formed at the upper surface substantially in a ring shape.

11. A method for making a system as set forth in claim 10 for a thickness of the layer between 5 to 50 µm per layer.

12. A method for making a system as set forth in claim 10 or 11 wherein the individual layers are visibly recognizable by means of the optical transitions.

13. A method for composing a mobile telephone comprising a system as set forth in one of claims 1 to 9, wherein the method provides the following steps:
a) mounting an SMD camera (15);
b) mounting a contact block (10, 11, 12) at the camera (15);
c) mounting a circuit board (4) of a mobile telephone at the contact block (10, 11, 12).

## Revendications

1. Système ou dispositif composé de :
a) un téléphone mobile comprenant un boitier (1), avec au moins deux parties de boitier (2, 3), une partie de boitier avant (2) et une partie de boitier arrière (3),
b) une caméra (15), en particulier une caméra SMD, montée sur la partie de boitier arrière (3) et ayant une zone de contacts (8) adaptée à une connexion électrique de la caméra (15) avec une zone de contacts (6) prévue sur un carte de circuit (4) qui peut être connectée avec la partie de boitier avant (2),
c) un bloc de contacts redimensionné (10, 11, 12) adapté à être inséré dans le boitier (1),
le bloc de contacts redimensionné (10, 11, 12) comprenant :
un corps isolant (16) comportant une première surface de butée de caméra qui comprend une première zone de contacts (9) pour contacter la zone de contacts (8) de la caméra (15) et
le corps isolant (16) comprenant en outre une deuxième surface de butée de carte de circuit comportant une deuxième zone de contacts (7) pour contacter la zone de contacts (6) de la carte de circuit (4) prévue pour la caméra SMD (15),
dans lequel le corps isolant (16) est prévu pour la connexion électrique de la zone de contacts (8) de la caméra (15) avec la zone de contacts (6) prévue pour la caméra (15), et dans lequel, dans le corps isolant, des conducteurs (17, 21) sont prévus pour connecter les contacts de la première zone de contacts (9) avec les contacts de la deuxième zone de contacts (7) du corps isolant (16), et
dans lequel la hauteur du bloc de contacts (10, 11, 12) qui correspond à la distance entre les première et deuxième surfaces de butée, est sélectionnée de telle sorte qu'elle couvre la distance de la caméra (15) à la carte de circuit (4) lorsque le boitier (1) est fermé.

2. Système selon la revendication 1, dans lequel les conducteurs sont des fils massifs et les extrémités des fils dépassant des surfaces de butée du corps isolant sont coupées.

3. Système selon la revendication 1, dans lequel les conducteurs ont une forme tubulaire.

4. Système selon une ou plusieurs des revendications précédentes, dans lequel le bloc de contacts (10, 11, 12) comprend une pluralité de couches.

5. Système selon une ou plusieurs des revendications précédentes, dans lequel le bloc de contacts (10, 11, 12) est en matière plastique durcie par des rayons UV.

6. Système selon une ou plusieurs des revendications précédentes, dans lequel le bloc de contacts (10, 11, 12) comprend une pluralité de canaux de contact qui sont métallisés au niveau de leur surface intérieure s'étendant entre la première surface de butée (25) et la deuxième surface de butée (26).

7. Système selon la revendication 6, dans lequel les canaux sont fermés en au moins un emplacement, au moyen de matière plastique, dans un plan du bloc de contacts de la caméra,
**caractérisé en ce que** la zone de contacts (7, 8) est munie d'une couche de dépôt électrolytique.

8. Système selon une ou plusieurs des revendications précédentes, dans lequel les zones de contact (7, 8) assurent, au niveau de la surface de butée, des points de contact sensiblement annulaires.

9. Système selon une ou plusieurs des revendications précédentes, dans lequel les couches individuelles ont une hauteur d'environ 5 à 50 µm.

10. Procédé pour réaliser un système selon l'une quelconque des revendications précédentes, le procédé comprenant les étapes suivantes :
a) prévoir une matière plastique liquide adaptée à être solidifiée par des rayons UV ;
b) mettre en place un masque, comportant une matrice définissant a) les zones qui doivent être durcies et b) les zones qui doivent rester non durcies ;
c) durcir une première couche de matière plastique adaptée à être durcie par des UV au moyen de rayons UV à travers le masque ;
d) construire étape par étape le bloc de contacts de caméra avec le nombre souhaité de parties de passage creuses (canaux) en répétant le procédé de l'étape c), au moyen de N étapes aussi longtemps que nécessaire pour construire la hauteur souhaitée du bloc de contacts de caméra ;
e) métalliser les canaux de passage à partir du côté inférieur jusqu'au côté supérieur du bloc de contacts ;
f) fermer les ouvertures restantes dans les canaux, de préférence au moyen de matière plastique durcissable en plaçant un masque approprié ;
g) déposer une couche de dépôt électrolytique sur les zones de surface métallisées formées au niveau de la surface supérieure avec une forme sensiblement annulaire.

11. Procédé pour réaliser un système selon la revendication 10 avec une épaisseur de couche comprise entre 5 et 50 µm par couche.

12. Procédé pour réaliser un système selon la revendication 10 ou 11, dans lequel les couches individuelles sont reconnaissables visuellement par des transitions optiques.

13. Procédé pour constituer un téléphone mobile comprenant un système selon l'une quelconque des revendications 1 à 9, le procédé comprenant les étapes suivantes :
a) monter une caméra SMD (15) ;
b) monter un bloc de contacts (10, 11, 12) sur la caméra (15) ;
c) monter une carte de circuit (4) de téléphone mobile sur le bloc de contacts (10, 11, 12).
